# FASCICULE DE BREVET EUROPEEN

(11) **EP 4 342 651 B1**
(45) Date de publication et mention de la délivrance du brevet: **19.03.2025**
(21) Numéro de dépôt: 23195297.9
(22) Date de dépôt: 05.09.2023
(51) Int. Cl.: B29C 45/14, B29C 45/16, H05K 3/36, H05K 1/14, H05K 3/40, H05K 1/18

(54) **DISPOSITIF ÉLECTRONIQUE MOULÉ ET PROCÉDÉ DE FABRICATION DU DISPOSITIF**
GEGOSSENE ELEKTRONISCHE VORRICHTUNG UND VERFAHREN ZUR HERSTELLUNG DER VORRICHTUNG
MOLDED ELECTRONIC DEVICE AND METHOD FOR MANUFACTURING THE DEVICE

(30) Priorité: 22.09.2022 FR 2209617
(43) Date de publication de la demande: 27.03.2024
(73) Titulaire: Faurecia Intérieur Industrie, 92000 Nanterre (FR)
(72) Inventeur: CUVILLIER, Christophe, 95310 SAINT OUEN L'AUMONE (FR); BROUSSELLE, Armand, 75010 PARIS (FR); TRILLAT, Sebastien, 78300 POISSY (FR); PESCE, Jean-Jacques, 60510 BRESLES (FR)
(74) Mandataire: Novagraaf Group

(56) Documents cités:
- WO-A2-2018/189419
- US-A- 5 519 201
- US-A- 5 757 622
- US-A1- 2004 074 671
- ANONYMOUS: "Functional Ink Systems for "In Mold Electronics" The Next Generation Human-Machine Interfaces", 1 January 2019 (2019-01-01), pages 1 - 23, XP093044796, Retrieved from the Internet <URL:https://www.dupont.com/content/dam/dupont/amer/us/en/mobility/public/documents/en/Functional-Ink-Systems-for-IME.pdf> [retrieved on 20230507]

## Description

### DOMAINE TECHNIQUE

La présente invention est relative à un dispositif électronique moulé, en particulier, un dispositif électronique réalisé selon la technologie dite plastronique ou dénommé « In-Mold Electronic » (IME).

### ETAT DE LA TECHNIQUE ANTERIEURE

Plus particulièrement, dans cette technique, une connexion électrique doit être assurée entre un circuit électronique de contrôle et un film sur lequel sont formées des pistes de connexion électrique et sur lequel sont placés des composants électroniques connectés par lesdites pistes de connexion électrique. Les pistes de connexion électrique sont par exemple formées par dépôt d'encre électriquement conductrice, par exemple par impression. Cette technologie peut par exemple être employée dans un équipement de véhicule, par exemple automobile. Par exemple, cette technique peut être employée dans un dispositif d'affichage pour véhicule, où des sources lumineuses servant à illuminer des pictogrammes du dispositif d'affichage sont disposées sur le film souple, et sont alimentées par un circuit électronique de contrôle sur une carte de circuit imprimé.

Un connecteur relie la carte de circuit imprimé et les pistes de connexion formées sur le film afin d'assurer l'alimentation et la commande des composants électroniques. Pour cela, les pistes de connexion électrique possèdent à l'emplacement du connecteur des plages de connexion. Dans les plages de connexion, chaque piste de connexion électrique est éventuellement élargie pour faciliter le contact électrique et assurer un contact électrique fiable avec un élément électrique du connecteur malgré des variations possibles et tolérances sur les positions et dimensions des différents éléments.

WO 2018/189419 A2 présente un dispositif électronique moulé avec un film de substrat qui accueille un certain nombre de conducteurs électriques. La structure contient au moins un support et éventuellement simultanément l'élément de fixation pour l'élément externe tel que le connecteur externe. L'élément de support dépasse de la surface inférieure de niveau ou du niveau du film de substrat vers l'environnement. L'élément de support peut être moulé à partir du matériau de la couche plastique pendant la formation de celui-ci. Un moule comprend des renfoncements ou d'autres formes correspondant à ceux de l'élément de support de sorte que le plastique fondu puisse remplir cet espace lors du moulage de la couche. À cette fin, le film contient un trou ou une partie au moins affaiblie par laquelle le plastique fondu peut pénétrer pendant le moulage pour établir la partie moulée de l'élément.

### EXPOSE DE L'INVENTION

La présente invention a pour but de perfectionner **dispositifs électroniques moulés,** et notamment d'améliorer la connexion avec un circuit électronique de contrôle externe.

A cet effet, le dispositif électronique moulé comprend :
un film,
des pistes de connexion électrique disposées sur le film, les pistes de connexion électrique comportant des plages de connexion configurées pour être connectées à des éléments conducteurs d'un connecteur, les pistes de connexion électrique s'étendant en partie selon une direction longitudinale, et ledit connecteur étant un connecteur élastique.

En outre, le dispositif électronique moulé comprend un support de connecteur moulé sur le film et sur les pistes de connexion électrique pour former des parois adaptées pour maintenir le connecteur au-dessus des plages de connexion et entre lesdites parois.

Grâce à ces dispositions, le support de connecteur est adapté à un connecteur souple en élastomère, en étant directement surmoulé sur le film souple imprimé des pistes de connexion électrique. Cette intégration du support de connecteur par surmoulage est moins chère, plus compacte que les solutions de connectiques actuelles.

### BREVE DESCRIPTION DES DESSINS

D'autres caractéristiques et avantages de l'invention apparaîtront au cours de la description suivante de modes de réalisation, donnés à titre d'exemples non limitatifs, en regard des dessins joints.

Sur les dessins :
- la figure 1 est une vue schématique d'un dispositif d'affichage comprenant un dispositif électronique moulé selon l'invention;
- la figure 2 est une vue de dessus de pistes et plages de connexion électrique ;
- la figure 3 est une vue de dessus d'un premier mode de réalisation d'un dispositif électrique moulé ;
- la figure 4A et la figure 4B sont des vues en coupe selon la direction A-A du dispositif de la figure 3, la figure 4A étant une vue à une première étape de fabrication du dispositif, et la figure 4B étant une vue à une seconde étape de fabrication du dispositif avec une couche supplémentaire ;
- la figures 5A et la figure 5B sont des vues en coupe selon la direction B-B du dispositif de la figure 3, la figure 5A étant une vue à la première étape de fabrication du dispositif, et la figure 5B étant une vue à la seconde étape de fabrication du dispositif avec une couche supplémentaire ;
- la figure 6 est une vue de dessus d'un deuxième mode de réalisation d'un dispositif électrique moulé ;
- la figure 7A est une vue en coupe selon la direction A1-A1 du dispositif de la figure 6;
- la figure 7B est une vue en coupe selon la direction A2-A2 du dispositif de la figure 6.

Sur les différentes figures, les mêmes références numériques désignent des éléments identiques ou similaires.

### DESCRIPTION DETAILLEE

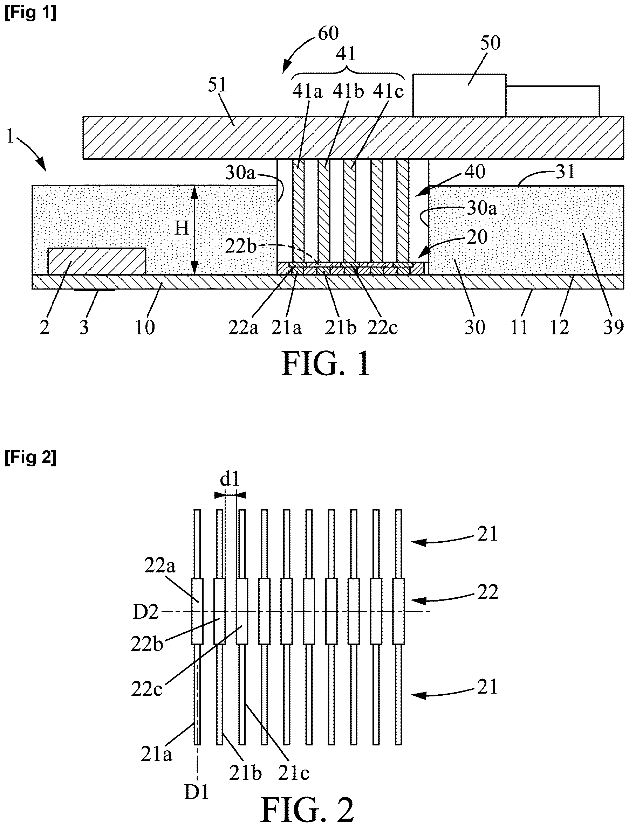

La **figure 1** montre un exemple d'application, à but simplement illustratif d'un dispositif électronique moulé 1 selon la présente divulgation. Le dispositif électronique moulé 1 est par exemple un dispositif d'intérieur de véhicule, par exemple de véhicule automobile.

Dans cet exemple de la figure 1, un dispositif d'affichage 60 d'un véhicule permet d'informer un utilisateur par exemple sur le fonctionnement d'équipements du véhicule, tels que la climatisation, ou le frein de parking.

Le dispositif d'affichage 60 comporte
- un dispositif électronique moulé 1 incluant un dispositif de connexion électrique 20 et un support de connecteur 30,
- un connecteur 40, et
- un circuit électronique de contrôle 50.

Le circuit électronique de contrôle 50 comporte une carte de circuit imprimé 51 sur lesquels sont disposés les divers composants et circuits électroniques. Le dispositif de connexion électrique 20 comporte des plages de connexion 22. Le dispositif de connexion 20 peut comporter un nombre quelconque de plages de connexion 22. Chaque plage de connexion 22 (22a, 22b, 22c, ...) est en contact électrique avec un élément conducteur de connexion du circuit électronique de contrôle 50 ou d'un connecteur 40.

Le dispositif d'affichage 60 comporte par exemple une source lumineuse 2. La connexion électrique entre la carte de circuit imprimée 51 du circuit électronique de contrôle 50 et la source lumineuse 2 est réalisée par l'intermédiaire d'un connecteur 40 et du dispositif de connexion électrique 20. Pour cela, les éléments conducteurs de connexion 41 (par exemple, une série d'éléments conducteurs 41a, 41b, 41c, ...) du connecteur 40 sont en contact avec les plages de connexion 22 (par exemple, une série de plages de connexion 22a, 22b, 22c, ...) du dispositif de connexion 20. La source lumineuse 2 est par exemple une diode électroluminescente, ou LED (pour « light-emitting diode » en anglais »).

Le dispositif d'affichage 60 considéré ici comporte un film 10, par exemple de type souple, sur lequel un pictogramme 3 est dessiné. Le film 10 constitue une surface visible du dispositif d'affichage 60. Le film 10 comporte une face 11 dite extérieure, qui est la surface faisant face à l'utilisateur et qui est accessible à l'utilisateur. Le film 10 comporte une face 12 dit intérieure, opposée à la face extérieure 11. La face intérieure 12 est tournée vers le fond du dispositif d'affichage et n'est pas accessible à l'utilisateur. Le pictogramme 3 est, sur l'exemple de la figure 1, imprimé sur la face extérieure 11 du film 10. Selon un mode de réalisation non représenté, le pictogramme peut aussi être imprimé sur la face intérieure 12 du film 10. La source lumineuse 2 est disposée sur le film 10, et est connectée électriquement par des pistes de connexion électrique 21 formées sur le film 10. Les pistes de connexion électrique 21 sont par exemple réalisées par impression d'une encre électriquement conductrice sur le film 10. L'encre électriquement conductrice est par exemple à base à base de cuivre ou d'argent.

Ces pistes de connexion électrique 21 sont reliées au circuit de contrôle 50 par l'intermédiaire des éléments conducteurs de connexion 41 du connecteur 40. Les pistes de connexion électrique 21 sont disposées sur la face intérieure 12 du film 10. La source lumineuse 2 est disposée sur la face intérieure 12 du film 10. Les pistes de connexion électrique 21 sont disposées sur la face intérieure 12 du film 10.

Un guide lumière peut être disposé de façon à transmettre la lumière émise par la source lumineuse 2 vers le pictogramme 3. Selon un mode de réalisation, ce guide lumière est surmoulé sur une partie du film 1 comprenant la source lumineuse 2.

Un matériau de support 39 est disposé sur la face intérieure 12 du film 10. Selon un mode de réalisation, le matériau de support 39 est surmoulé sur une partie de la face intérieure 12 du film 10. Le matériau de support 39 permet de rigidifier le film 10 pour former le dispositif électronique moulé 1.

Le matériau de support 39 peut être un matériau opaque. Il est par exemple disposé autour du guide lumière.

Le matériau de support 39 est agencé pour former un support de connecteur 30 adapté pour laisser libres les plages de connexion 22 et pour laisser libre un passage pour le connecteur 40.

Selon un mode de réalisation, le dispositif d'affichage 60 et/ou le dispositif électronique moulé 1 comprend d'autres composants électroniques.

Le dispositif électronique moulé 1 selon la présente divulgation, comprend :
- le film 10,
au moins une piste de connexion électrique 21 disposée sur le film , la piste de connexion électrique 21 comportant une plage de connexion 22 configurée pour être connectée à un élément conducteur d'un connecteur 40, la piste de connexion électrique 21 s'étendant en partie selon une direction longitudinale D1, par exemple dans la plage de connexion 22, et ledit connecteur étant un connecteur élastique.

Avantageusement, le dispositif électronique moulé 1 comprend au moins deux pistes de connexion électrique 21 du même type que la piste décrite ci-dessus. Par exemple, les au moins deux pistes de connexion électrique 21 sont parallèles l'une de l'autre. Usuellement, le dispositif électronique moulé 1 comprend des pistes de connexion électrique 21, i.e. une pluralité de pistes de connexion électronique. Par simplification de la description et par cohérence avec les figures, il sera décrit dans la présente description le cas d'un dispositif électronique moulé comprenant plusieurs pistes de connexion électronique 21.

Le dispositif électronique moulé 1 comprend en outre un support de connecteur 30 moulé sur le film et sur les pistes de connexion électrique 21 pour former des parois 30a adaptées pour maintenir le connecteur au-dessus des plages de connexion 22 et entre lesdites parois.

Le film 10 est par exemple de type souple. Par « souple », il est compris que le film 10 est réalisé en une matière et/ou avec des dimensions (par exemple une épaisseur) telles que le film 10 est apte à se déformer sous son propre poids lorsque ledit film 10 est posé sur deux appuis éloignés. Notamment, le module d'Young du film 10 peut être compris entre 2000 MPa et 3500 MPa .

Le film 10 est par exemple constitué d'un matériau polymère. Le film 10 peut par exemple être en polycarbonate (PC), ou en polyméthacrylate de méthyle (PMMA). Le film 10 a par exemple une épaisseur comprise entre 175 microns et 750 microns.

Le support de connecteur 30 entoure les plages de connexion 22. Le support de connecteur 30 est donc surmoulé sur les pistes de connexion 21.

Le support de connecteur 30 est par exemple constitué d'un matériau polymère. Le support de connecteur 30 peut par exemple être en polycarbonate (PC), en acrylonitrile butadiène styrène (ABS), ou en copolymère polycarbonate/ acrylonitrile butadiène styrène (PC/ABS), ou en polyméthacrylate de méthyle (PMMA). Le matériau du support de connecteur 30 peut comprendre une charge, telle que des fibres de verre.

Le support de connecteur 30 a par exemple une hauteur H supérieure à 5 mm. La hauteur H est définie comme étant la distance maximale dans une direction perpendiculaire au plan moyen du film 10 (c'est-à-dire perpendiculaire aux directions D1 et D2, définies plus loin en regard de la figure 2), entre la face intérieure 12 du film 10 et un point de la face intérieure 31 dudit support de connecteur 30.

Le support de connecteur 30 a des parois 30a d'une hauteur suffisante et qui entourent le connecteur 40 pour être apte à maintenir le connecteur 40 dans ledit support de connecteur 30. Le support de connecteur est par exemple formé au moins en partie dans le matériau de support 39.

Le connecteur 40 est un connecteur élastique. Par exemple, ce connecteur 40 est élastique dans une direction sensiblement perpendiculaire au film 10 du dispositif électronique 1. Ainsi, il peut être maintenu par pression entre le dispositif électronique 1 et le circuit électronique de contrôle 50, par divers moyens de pression, et par exemple par vis ou clips adaptés pour la fixation du circuit électronique de contrôle 50 sur le dispositif électronique moulé 1, ou l'inverse.

Par exemple, le connecteur 40 comprend un élément de connectique rigide monté sur un élément élastique, tel qu'un ressort ou un élément en élastomère.

Par exemple, le connecteur 40 est un connecteur en élastomère comprenant une alternance de couches isolantes et de couches conductrices, ces couches conductrices étant appelées dans la présente divulgation des éléments conducteurs 41 (par exemple une série d'éléments conducteurs 41a, 41b, 41c...). Des connecteurs de ce type sont connus, et sont parfois commercialisés sous la marque Zebra ^{®}. Ces connecteurs ont pour avantage de s'adapter à la forme du support et d'être économiques, mais ils peuvent provoquer des défauts de connexion électrique s'ils ne sont pas bien maintenus. Ces connecteurs devant être démontables, il n'y a aucune adhésion entre les plages de connexion 22 et le connecteur 40. Ainsi des pièces additionnelles sont généralement montées par vissage sur un support afin d'accepter un tel connecteur, ces pièces additionnelles étant adaptées pour maintenir le connecteur latéralement dans une direction à un plan moyen film 10 et pour maintenir le connecteur par pression dans la direction sensiblement perpendiculaire à ce plan moyen film 10. Le dispositif moulé 1 selon la présente divulgation n'a pas besoin d'une telle pièce additionnelle de maintien grâce au support de connecteur 30 surmoulé directement sur les pistes de connexion électrique et sur le film souple. Ainsi, grâce à ce support de connecteur 30, ce type de connecteur élastique est utilisable sur un film souple de circuit électrique.

Le connecteur 40 a par exemple un module d'Young compris entre 0,1 MPa et 100 MPa.

En outre, le connecteur 40 est une pièce distincte du dispositif électronique moulé 1 et du circuit électronique de contrôle 50, de sorte que le montage et la connexion électrique entre le film 10 et la carte de circuit imprimé 51 sont facilités, et tolérants aux variations dimensionnelles et aux positions relatives des éléments.

La **figure 2** illustre une vue de dessus des pistes de connexion 21 (par exemple une série 21a, 21b, 21c) et des plages de connexions 22 (par exemple une série 22a, 22b, 22c, ...) réalisées sur le film 10 du dispositif électronique moulé 1. La distance entre deux plages de connexion voisines 22a, 22b est y schématisée par le signe d1. On entend par plages de connexion voisines, deux plages de connexion adjacentes l'une de l'autre, et alignées selon une direction transverse D2 perpendiculaire à la direction longitudinale D1 des pistes de connexion 21. Les plages de connexion voisines peuvent éventuellement être décalées l'une par rapport à l'autre selon la direction longitudinale D1.

**Dans divers modes de réalisation** de la présente divulgation, le support de connecteur 30 est réalisé de telle sorte que les pistes de connexion ne soient pas altérées par le surmoulage du matériau du support de connecteur 30.

Notamment, le support de connecteur 30 comprend en regardant dans une direction perpendiculaire à un plan moyen du film 10, c'est-à-dire perpendiculaire aux directions D1 et D2 :
- des premières portions 30-1 qui sont moulées sur les pistes de connexion électrique 21, c'est-à-dire des premières portions qui sont superposées au-dessus des pistes de connexion électrique, et
- des deuxièmes portions 30-2 qui sont moulées sur le film 10, directement, sans se superposer à une piste de connexion électrique 21.

Les premières portions 30-1 du support de connecteur 30 sont en contact direct avec les pistes de connexion 21, ou en contact avec les pistes de connexion 21 par l'intermédiaire d'une couche d'adhésion. Une telle couche d'adhésion n'est pas installée sur les plages de connexion 22 destinées au contact électrique avec le connecteur 40.

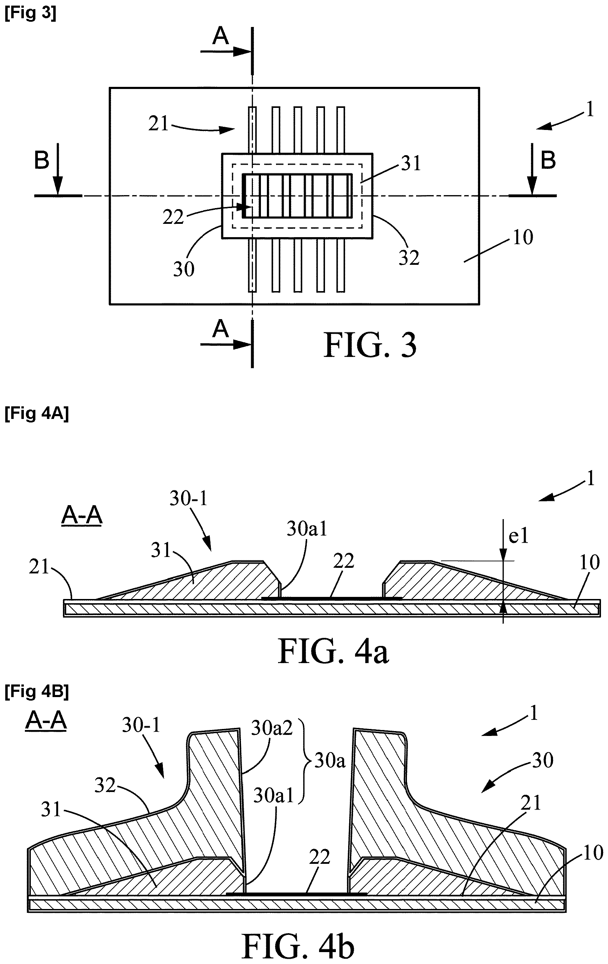

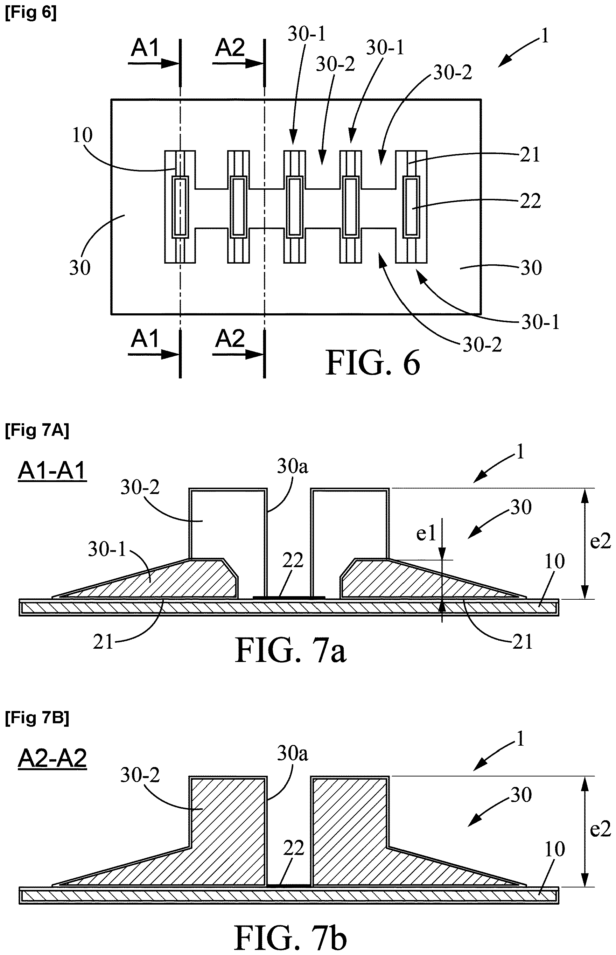

Comme le support de connecteur 30 entoure les plages de connexion 22, le support de connexion 30 possède alternativement, sur sa périphérie autour des plages de connexion 22, des premières portions 30-1 et des deuxièmes portions 30-2, comme cela est visible sur la figure 3 et la figure 6.

Selon une variante de la présente divulgation, les premières portions 30-1 moulées au-dessus et superposées aux pistes de connexion électrique 21 ont une épaisseur, dite première épaisseur comprise entre 0,5 mm et 2,5 mm.

En variante, le support de connecteur 30 peut être réalisé par une superposition successive de plusieurs couches. Une première couche du support de connecteur 30 ou plus précisément une première couche des premières portions 30-1 du support de connecteur 30 a une première épaisseur comprise entre 0,5 mm et 2,5 mm. Par première couche, on entend une couche du support de connecteur 30 réalisée au plus proche du film 10 et/ou des pistes de connexion 21. Ainsi cette première épaisseur concerne les premières portions 301 ou une première couche desdites premières portions du support de connecteur 30.

Ainsi, l'épaisseur de matière au-dessus des pistes de connexion électrique 21 est limitée, et ces premières portions 30-1 situées au-dessus des pistes de connexion électrique 21 ne détériorent pas les pistes de connexion électrique 21 pendant leur réalisation par moulage, car le retrait de moulage lors du refroidissement est alors également limité. On évite des déformations et/ou ruptures de pistes de connexion électrique.

En variante, la première épaisseur est inférieure à 1,5 mm. Ainsi, l'épaisseur de matière située au-dessus des pistes de connexion électrique 21 ne les détériorent pas.

Selon une variante de la présente divulgation, premières portions 30-1 ou une première couche réalisée desdites premières portions ont une première épaisseur diminuant en s'éloignant des plages de connexion 22 dans la direction longitudinale D1, c'est-à-dire en s'éloignant de l'intérieur du support connexion 30, qui accueille le connecteur 40.

Ainsi, l'épaisseur de matière au-dessus des pistes de connexion est limitée. On évite les déformations et/ou ruptures des pistes de connexion électrique par le retrait de moulage de ces premières portions 30-1 du support de connexion 30, tout en formant au moins une première partie 30a1 des parois 30a. Le moulage ne détériore pas les pistes de connexion 21.

En outre, l'épaisseur au droit de la première partie 30a1 des parois 30a peut être inférieure à la première épaisseur. Autrement dit, une réduction d'épaisseur peut être formée au droit de la première partie 30a1 des parois 30a, comme cela est visible en figure 4A.

**Selon un premier mode de réalisation** de la présente divulgation illustré en **figure 3, figure 4A, figure 4B****,** **figure 5A, et figure 5B****,** le dispositif électronique moulé 1, et notamment le support de connecteur 30 est réalisé par la superposition successive de plusieurs couches sur le film 10 et ses pistes de connexion électrique 21. Chaque couche est moulée sur la précédente et solidifiée avant la suivante. Une succession de formes de moule sont prévus pour les injections successives de ces couches. Par simplicité, la présente divulgation explicitera la réalisation en deux couches, mais plus de deux couches sont aisément envisageables.

La figure 3 est une vue de dessus du dispositif électronique moulé 1 de ce premier mode de réalisation, dans lequel le support de connecteur 30 comprend deux couches moulées. Une première couche 31 du support de connecteur 30 est moulée sur le film 1 et les piste de connexion électrique 21. Cette première couche 31 se superposer aux pistes de connexion électrique 21 autour des plages de connexion 22. Avantageusement, la première couche 31 peut entourer les plages de connexion 22. La deuxième couche 32 entoure les plages de connexion 22 en se superposant à la première couche 31.

La figure 4A et la figure 4B sont des vues en coupe du dispositif de la figure 3 selon la coupe A-A de la figure 3, i.e. selon la direction longitudinale D1 et passant par une piste de connexion 21.

La figure 4A illustre la réalisation de la première couche 31 du support de connecteur 30 dans la vue de la coupe A-A de figure 3. La première couche 31 est moulée par injection sur les pistes de connexion électrique 21, et éventuellement sur le film 10. Cette première couche 31 a une épaisseur, dite première épaisseur e1, comprise entre 0,5 mm et 2,5 mm. Typiquement, cette première épaisseur est inférieure à 1,5 mm. Ainsi, cette première couche 31 forme une première partie 30a1 de la paroi 30a du support de connecteur 30. Cette première partie 30a1 de la paroi 30a s'élève sensiblement perpendiculairement au film 10 et fait face aux plages de connexion 22.

Grâce à cette première couche 31 de faible épaisseur formée avant une deuxième couche 32, les pistes de connexion électrique 21 situées sous cette première couche 31 sont peu ou pas déformées, et non détériorées par ce surmoulage, et notamment le problème de retrait de moulage, qui est faible dans le cas de cette première couche 31.

Selon une variante, cette première couche 31 a une première épaisseur e1 qui diminue en s'éloignant des plages de connexion 22. Les pistes de connexion électrique 21 sont bien maintenues au niveau de la paroi 30a et bien protégées d'un retrait du moulage. On évite donc toute dégradation des pistes de connexion électrique 21. Les pistes de connexion électrique 21 ne sont pas déformées ou détériorées par cette première couche 31 de faible épaisseur, comprise entre 0,5 mm et 2,5 mm, et de préférence inférieure à 1,5 mm.

La figure 4B illustre la réalisation de la deuxième couche 32 du support de connecteur 30 dans la vue de la coupe A-A de figure 3, ladite deuxième couche 32 étant moulée par injection sur la première couche 31. La deuxième couche 32 permet de former une deuxième partie 30a2 de la paroi 30a du support de connecteur 30. Cette deuxième couche 32 peut s'étendre vers le haut sensiblement perpendiculairement au film 10 jusqu'à une hauteur suffisante pour maintenir le connecteur 40. La hauteur totale des parois 30a du support de connecteur 30 est par exemple comprise entre 2 mm et 30 mm.

Selon une variante, la première couche 31 est réalisée avec un premier matériau ; et la deuxième couche 32 est réalisée avec un deuxième matériau. Eventuellement, les premier et deuxième matériaux sont différents.

La première partie 30a1 et la deuxième partie 30a2 de la paroi 30a sont par exemple alignées verticalement. C'est-à-dire que la deuxième partie 30a2 est dans le prolongement de la première partie 30a1, comme cela est visible en figure 4B.

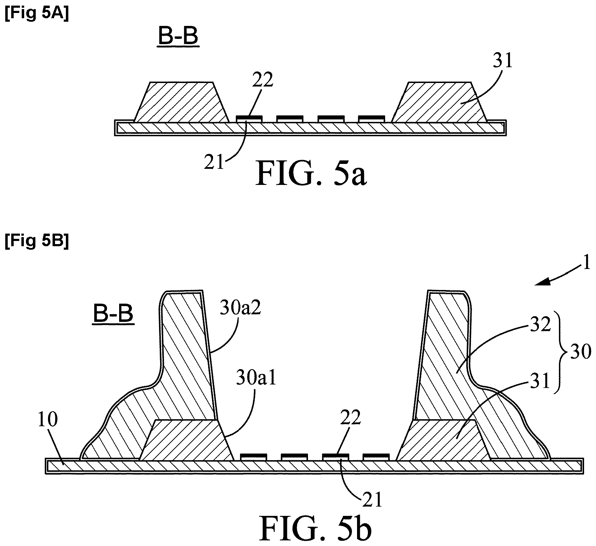

Cependant, la première partie 30a1 et la deuxième partie 30a2 de la paroi 30a ne sont pas forcément alignées verticalement, comme cela est visible en figure 5B qui montre l'élévation dans la direction D2. En effet, le connecteur 40 nécessite surtout un maintien mécanique dans la direction longitudinale D1, qui correspond à la dimension la plus petite dudit connecteur 40.

La figure 5A et la figure 5B sont des vues en coupe du dispositif de la figure 3 selon la coupe B-B de la figure 3, i.e. dans la la direction D2, perpendiculairement à la direction D1 d'une piste de connexion 21.

La figure 5A illustre la réalisation de la première couche 31 dans la vue de la coupe B-B de figure 3. La figure 5B illustre la réalisation de la deuxième couche 32 du support de connecteur 30 dans la vue de la coupe B-B de figure 3, ladite deuxième couche 32 étant moulée par injection sur la première couche 31. Ces figures montrent les pistes de connexion électrique 21 coupées transversalement (dans la direction D2) et donc l'élévation de la première partie 30a1 et la deuxième partie 30a2 de la paroi 30a dans cette direction.

**Selon un deuxième mode de réalisation** de la présente divulgation illustré en **figure 6, figure 7A,** et **figure 7B****,** le support de connecteur 30 est réalisé par une unique couche sur le film 10 et ses pistes de connexion électrique 21.

La figure 6 est une vue de dessus du dispositif électronique moulé 1, de ce deuxième mode de réalisation, dans lequel le support de connecteur 30 a différentes épaisseurs. Notamment, le support de connecteur 30 a une première épaisseur e1 dans des zones (première portions) situées au-dessus des pistes de connexion électrique 21, et une deuxième épaisseur e2, plus grande que la première épaisseur, dans des zones (deuxième portions) sans piste de connexion électrique.

La figure 7A illustre la réalisation du support de connecteur 30 dans la vue de la coupe A1-A1 de figure 6, et la figure 7B illustre la réalisation du support de connecteur 30 dans la vue de la coupe A2-A2 de figure 6. Ces vues en coupe permettent de visualiser les élévations, et donc les épaisseurs dans les diverses premières portions 30-1 et deuxièmes portions 30-2 du support de connecteur 30. En figure 7B, la plage de connexion 22 n'est pas dans le plan de coupe, mais vue en arrière-plan.

Ainsi, le support de connecteur 30 comprend :
- des premières portions 30-1 situées au-dessus des pistes de connexion électrique 21, lesdites premières portions 30-1 ayant une première épaisseur e1,
- des deuxièmes portions 30-2 non situées au-dessus des pistes de connexion électrique 21, ou autrement dit situées sur le film 10 à l'écart des pistes de connexion électriques dans la direction D2, lesdites deuxièmes portions 30-2 ayant une deuxième épaisseur e2.

La deuxième épaisseur e2 est supérieure à la première épaisseur e1. Avantageusement, la deuxième épaisseur e2 est par exemple au moins deux fois supérieure à la première épaisseur e1. Ainsi, l'épaisseur du support de connexion 30 est réduite au-dessus des pistes de connexion, et on évite de détériorer les pistes de connexion 21, tout en conservant un bon maintien du connecteur 40 par le support de connecteur 30 grâce aux deuxièmes portions plus épaisses.

En outre, selon une variante, les parois des premières portions 30-1 sont plus éloignées des pages de connexion 22 que les parois des deuxièmes portions 30-2 selon la direction D1, comme cela est visible en figure 7A.Ainsi, on évite encore plus la détérioration des pistes de connexion 21 par le surmoulage du support de connecteur 30, tout en améliorant le maintien par les deuxièmes portions, plus proche des plages de connexion 22. Dans un tel cas, en vue de dessus de la figure 6, le support de connecteur 30 a une forme générale en créneaux qui entoure les plages de connexion 22. Le connecteur 40 est alors maintenu par les avancées des deuxièmes portions 30-2 (également d'une épaisseur supérieure), et ce connecteur 40 souple est bien maintenu dans le support de connexion 30, au-dessus des plages de connexion 22 pour effectuer un contact électrique fiable.

Enfin, une telle disposition avec des avancées du support de connecteur 30 entre les pistes de connexion électrique est également utilisable dans le premier mode de réalisation avec le moulage de deux couches de matériau de support de connecteur.

**Le procédé de fabrication du dispositif électronique moulé 1** et de son support de connecteur 30 transparait dans la description du produit ci-dessus et notamment par les étapes de fabrication de moulage par injection illustrées dans la figure 4A, figure 4B, figure 5A, et figure 5B pour le premier mode de réalisation, et par l'injection par moulage illustrée dans la figure 7A et la figure 7B pour le deuxième mode de réalisation.

Ainsi, le procédé de fabrication d'un dispositif électronique moulé 1 comprend les étapes de :
- fourniture d'un film,
- formation de pistes de connexion électrique 21 disposées sur le film 10, les pistes de connexion électrique 21 comportant des plages de connexion 22 configurées pour être connectées à des éléments conducteurs d'un connecteur 40, les pistes de connexion électrique s'étendant en partie selon une direction longitudinale D1, et ledit connecteur étant un connecteur élastique,
- formation d'un support de connecteur 30 par moulage sur le film et sur les pistes de connexion électrique 21 pour former des parois 30a adaptées pour maintenir le connecteur au-dessus des plages de connexion 22 et entre lesdites parois.

Le support de connecteur 30 a par exemple des premières portions 30-1 situées au-dessus des pistes de connexion électrique 21, lesdites premières portions 30-1 ou une première couche 31 des premières portions ayant une première épaisseur e1 comprise entre 0,5 mm et 2,5 mm.

Le support de connecteur 30 est par exemple réalisé par :
- formation d'une première couche 31 par moulage sur les pistes de connexion électrique 21, ladite première couche 31 ayant une première épaisseur e1 comprise entre 0,5 mm et 2,5 mm, et ladite première couche 31 formant une première partie 30a1 des parois 30a, et
- formation d'une deuxième couche 32 par moulage sur la première couche 31 et formant une deuxième partie 30a2 des parois 30a,
ladite deuxième couche 32 étant formée sur la première couche 31 après refroidissement de la première couche 31.

Enfin, le ou les moulages sont des moulages par injection.

## Revendications

1. **Dispositif électronique moulé (1)** comprenant :
un film (10),
des pistes de connexion électrique (21) disposées sur le film (10), les pistes de connexion électrique (21) comportant des plages de connexion (22) configurées pour être connectées à des éléments conducteurs d'un connecteur (40), les pistes de connexion électrique s'étendant en partie selon une direction longitudinale (D1), et ledit connecteur étant un connecteur élastique, et
dans lequel ledit dispositif électronique moulé comprend en outre un support de connecteur (30) moulé sur le film et sur les pistes de connexion électrique (21) pour former des parois (30a) adaptées pour maintenir le connecteur au-dessus des plages de connexion (22) et entre lesdites paroisdans lequel le support de connecteur (30) a des premières portions (30-1) situées au-dessus des pistes de connexion électrique (21), lesdites premières portions (30-1) ou une première couche (31) des premières portions (30-1) ayant une première épaisseur (e1) comprise entre 0,5 mm et 2,5 mm.

2. Dispositif selon la revendication 1, dans lequel la première épaisseur (e1) est inférieure à 1,5 mm.

3. Dispositif selon l'une des revendications 1 et 2, dans lequel le support de connecteur (30) comprend des premières portions (30-1) situées au-dessus des pistes de connexion électrique (21), lesdites premières portions (30-1) ou une première couche (31) des premières portions ayant une première épaisseur (e1) diminuant en s'éloignant dans la direction longitudinale (D1) des plages de connexion (22).

4. Dispositif selon l'une des revendications 1 à 3, dans lequel les parois (30a) du support de connecteur (30) entourent les plages de connexion (22).

5. Dispositif selon l'une des revendications 1 à 4, dans lequel le support de connecteur (30) est formé par :
une première couche (31) moulée sur les pistes de connexion électrique (21), ladite première couche (31) ayant une première épaisseur (e1) comprise entre 0,5 mm et 2,5 mm, et ladite première couche (31) formant une première partie (30a1) des parois (30a), et
une deuxième couche (32) moulée sur la première couche (31) et formant une deuxième partie (30a2) des parois (30a).

6. Dispositif selon la revendication 5, dans lequel la deuxième partie (30a2) des parois est dans le prolongement de la première partie (30a1) des parois, pour au moins les parois sensiblement perpendiculaires à la direction longitudinale (D1).

7. Dispositif selon l'une des revendications 1 à 4, dans lequel, le support de connecteur (30) comprend :
des premières portions (30-1) situées au-dessus des pistes de connexion électrique (21), lesdites premières portions (30-1) ayant une première épaisseur (e1),
des deuxièmes portions (30-2) non situées au-dessus des pistes de connexion électrique (21), lesdites deuxièmes portions (30-2) ayant une deuxième épaisseur (e2),
la deuxième épaisseur étant au moins deux fois supérieure à la première épaisseur.

8. **Procédé de fabrication** d'un dispositif électronique moulé comprenant les étapes de :
fourniture d'un film,
formation de pistes de connexion électrique (21) disposées sur le film (10), les pistes de connexion électrique (21) comportant des plages de connexion (22) configurées pour être connectées à des éléments conducteurs d'un connecteur (40), les pistes de connexion électrique s'étendant en partie selon une direction longitudinale (D1), et ledit connecteur étant un connecteur élastique,
formation d'un support de connecteur (30) par moulage sur le film et sur les pistes de connexion électrique (21) pour former des parois (30a) adaptées pour maintenir le connecteur au-dessus des plages de connexion (22) et entre lesdites parois, dans lequel le support de connecteur (30) a des premières portions (30-1) situées au-dessus des pistes de connexion électrique (21), lesdites premières portions (30-1) ou une première couche (31) des premières portions ayant une première épaisseur (e1) comprise entre 0,5 mm et 2,5 mm.

9. Procédé selon la revendication 8, dans lequel le support de connecteur (30) est réalisé par :
formation d'une première couche (31) par moulage sur les pistes de connexion électrique (21), ladite première couche (31) ayant une première épaisseur (e1) comprise entre 0,5 mm et 2,5 mm, et ladite première couche (31) formant une première partie (30a1) des parois (30a), et
formation d'une deuxième couche (32) par moulage sur la première couche (31) et formant une deuxième partie (30a2) des parois (30a),
ladite deuxième couche (32) étant formée sur la première couche (31) après refroidissement de la première couche (31).

10. Procédé selon l'une des revendications 8 et 9, dans lequel le ou les moulages sont des moulages par injection.

## Patentansprüche

1. **Geformte elektronische Vorrichtung (1),** umfassend:
eine Folie (10),
Stromanschlussbahnen (21), die auf der Folie (10) angeordnet sind, wobei die Stromanschlussbahnen (21) Anschlusspads (22) vorweisen, die konfiguriert sind, um mit leitenden Elementen eines Verbinders (40) verbunden zu sein, wobei sich die Stromanschlussbahnen teilweise in einer Längsrichtung (D1) erstrecken und wobei der Verbinder ein elastischer Verbinder ist, und
wobei die geformte elektronische Vorrichtung ferner einen Verbinderträger (30), der auf der Folie und auf den Stromanschlussbahnen (21) zum Ausbilden von Wänden (30a) geformt ist, die zum Halten des Verbinders über den Anschlusspads (22) und zwischen den Wänden geeignet sind, umfasst, wobei der Verbinderträger (30) erste Abschnitte (30-1) aufweist, die über den Stromanschlussbahnen (21) gelegen sind, wobei die ersten Abschnitte (30-1) oder eine erste Schicht (31) der ersten Abschnitte (30-1) eine erste Dicke (e1), die zwischen 0,5 mm und 2,5 mm liegt, aufweisen.

2. Vorrichtung nach Anspruch 1, wobei die erste Dicke (e1) weniger als 1,5 mm beträgt.

3. Vorrichtung nach einem der Ansprüche 1 und 2, wobei der Verbinderträger (30) erste Abschnitte (30-1), die über den Stromanschlussbahnen (21) gelegen sind, umfasst, wobei die ersten Abschnitte (30-1) oder eine erste Schicht (31) der ersten Abschnitte eine erste Dicke (e1) aufweisen, die mit zunehmender Entfernung in der Längsrichtung (D1) von den Anschlusspads (22) abnimmt.

4. Vorrichtung nach einem der Ansprüche 1 bis 3, wobei die Wände (30a) des Verbinderträgers (30) die Anschlusspads (22) umgeben.

5. Vorrichtung nach einem der Ansprüche 1 bis 4, wobei der Verbinderträger (30) ausgebildet ist durch:
eine erste Schicht (31), die auf den Stromanschlussbahnen (21) geformt ist, wobei die erste Schicht (31) eine erste Dicke (e1), die zwischen 0,5 mm und 2,5 mm liegt, aufweist und die erste Schicht (31) einen ersten Teil (30a1) der Wände (30a) ausbildet und
eine zweite Schicht (32), die auf der ersten Schicht (31) geformt ist und einen zweiten Teil (30a2) der Wände (30a) ausbildet.

6. Vorrichtung nach Anspruch 5, wobei der zweite Teil (30a2) der Wände in der Verlängerung des ersten Teils (30a1) der Wände liegt, wobei die Wände mindestens im Wesentlichen senkrecht zu der Längsrichtung (D1) sind.

7. Vorrichtung nach einem der Ansprüche 1 bis 4, wobei der Verbinderträger (30) umfasst:
erste Abschnitte (30-1), die über den Stromanschlussbahnen (21) gelegen sind, wobei die ersten Abschnitte (30-1) eine erste Dicke (e1) aufweisen,
zweite Abschnitte (30-2), die nicht über den Stromanschlussbahnen (21) gelegen sind, wobei die zweiten Abschnitte (30-2) eine zweite Dicke (e2) aufweisen,
wobei die zweite Dicke mindestens zwei Mal so groß wie die erste Dicke ist.

8. **Herstellungsverfahren** einer geformten elektronischen Vorrichtung, umfassend die Schritte:
Liefern einer Folie,
Ausbilden von Stromanschlussbahnen (21), die auf der Folie (10) angeordnet sind, wobei die Stromanschlussbahnen (21) Anschlusspads (22) vorweisen, die konfiguriert sind, um mit leitenden Elementen eines Verbinders (40) verbunden zu sein, wobei sich die Stromanschlussbahnen teilweise in einer Längsrichtung (D1) erstrecken und wobei der Verbinder ein elastischer Verbinder ist,
Ausbilden eines Verbinderträgers (30) durch Formguss auf der Folie und auf den Stromanschlussbahnen (21), zum Ausbilden von Wänden (30a), die zum Halten des Verbinders über den Anschlusspads (22) und zwischen den Wänden geeignet sind, wobei der Verbinderträger (30) erste Abschnitte (30-1) aufweist, die über den Stromanschlussbahnen (21) gelegen sind, wobei die ersten Abschnitte (30-1) oder eine erste Schicht (31) der ersten Abschnitte eine erste Dicke (e1), die zwischen 0,5 mm und 2,5 mm liegt, aufweisen.

9. Verfahren nach Anspruch 8, wobei der Verbinderträger (30) erstellt wird durch:
Ausbilden einer ersten Schicht (31) durch Formguss auf den Stromanschlussbahnen (21), wobei die erste Schicht (31) eine erste Dicke (e1), die zwischen 0,5 mm und 2,5 mm liegt, aufweist und die erste Schicht (31) einen ersten Teil (30a1) der Wände (30a) ausbildet und
Ausbilden einer zweiten Schicht (32) durch Formguss auf der ersten Schicht (31) und Ausbilden eines zweiten Teils (30a2) der Wände (30a),
wobei die zweite Schicht (32) auf der ersten Schicht (31) nach einem Abkühlen der ersten Schicht (31) ausgebildet wird.

10. Verfahren nach einem der Ansprüche 8 und 9, wobei der Formguss oder die Formgüsse Spritzformgüsse sind.

## Claims

1. **A molded electronic device (1)** comprising:
a film (10),
electrical connection tracks (21) arranged on the film (10), the electrical connection tracks (21) comprising connection pads (22) configured to be connected to conductive elements of a connector (40), the electrical connection tracks extending in part along a longitudinal direction (D1), and said connector being an elastic connector, and
wherein said molded electronic device further comprises a connector support (30) molded onto the film and onto the electrical connection tracks (21) in order to form walls (30a) adapted to hold the connector above the connection pads (22) and between said walls wherein the connector support (30) has first portions (30-1) located above the electrical connection tracks (21), said first portions (30-1) or a first layer (31) of the first portions (30-1) having a first thickness (e1) between 0.5 mm and 2.5 mm.

2. The device according to claim 1, wherein the first thickness (e1) is less than 1.5 mm.

3. The device according to one of claims 1 and 2, wherein the connector support (30) comprises first portions (30-1) located above the electrical connection tracks (21), said first portions (30-1) or a first layer (31) of the first portions having a first thickness (e1) decreasing moving in the longitudinal direction (D1) from the connection pads (22).

4. The device according to one of claims 1 to 3, wherein the walls (30a) of the connector support (30) surround the connection pads (22).

5. The device according to one of claims 1 to 4, wherein the connector support (30) is formed by:
a first layer (31) molded onto the electrical connection tracks (21), said first layer (31) having a first thickness (e1) between 0.5 mm and 2.5 mm, and said first layer (31) forming a first part (30a1) of the walls (30a), and
a second layer (32) molded onto the first layer (31) and forming a second part (30a2) of the walls (30a).

6. The device according to claim 5, wherein the second part (30a2) of the walls is in line with the first part (30a1) of the walls, for at least the walls substantially perpendicular to the longitudinal direction (D1).

7. The device according to one of claims 1 to 4, wherein the connector support (30) comprises:
first portions (30-1) located above the electrical connection tracks (21), said first portions (30-1) having a first thickness (e1),
second portions (30-2) not located above the electrical connection tracks (21), said second portions (30-2) having a second thickness (e2),
wherein the second thickness is at least two times greater than the first thickness.

8. **A method for manufacturing** a molded electronic device comprising the steps of:
providing a film,
forming electrical connection tracks (21) arranged on the film (10), the electrical connection tracks (21) comprising connection pads (22) configured to be connected to conductive elements of a connector (40), the electrical connection tracks extending partially along a longitudinal direction (D1), and said connector being an elastic connector,
forming a connector support (30) by molding onto the film and on the electrical connection tracks (21) to form walls (30a) adapted to hold the connector above the connection pads (22) and between said walls, wherein the connector support (30) has first portions (30-1) located above the electrical connection tracks (21), said first portions (30-1) or a first layer (31) of the first portions having a first thickness (e1) between 0.5 mm and 2.5 mm.

9. The method according to claim 8, wherein the connector support (30) is produced by:
forming a first layer (31) by molding onto the electrical connection tracks (21), said first layer (31) having a first thickness (e1) of between 0.5 mm and 2.5 mm, and said first layer (31) forming a first part (30a1) of the walls (30a), and
forming a second layer (32) by molding onto the first layer (31) and forming a second part (30a2) of the walls (30a),
said second layer (32) being formed on the first layer (31) after cooling of the first layer (31).

10. The method according to one of claims 8 and 9, wherein the molding(s) are injection moldings.
